# EUROPÄISCHE PATENTSCHRIFT

(11) **EP 2 482 302 B1**
(45) Veröffentlichungstag und Bekanntmachung des Hinweises auf die Patenterteilung: **30.11.2016**
(21) Anmeldenummer: 12000231.6
(22) Anmeldetag: 17.01.2012
(51) Int. Cl.: H01J 37/145, H01J 37/153, H01J 37/26

(54) **Korrektor**
Corrector
Correcteur

(30) Priorität: 01.02.2011 DE 102011009954
(43) Veröffentlichungstag der Anmeldung: 01.08.2012
(73) Patentinhaber: CEOS Corrected Electron Optical Systems GmbH, 69120 Heidelberg (DE)
(72) Erfinder: Zach, Joachim, 76684 Östringen (DE)
(74) Vertreter: Weber & Seidel

(56) Entgegenhaltungen:
- EP-A1- 1 318 539
- EP-A2- 2 068 344

## Beschreibung

Die Erfindung betrifft einen Korrektor für die Farb- und Öffnungsfehlerkorrektur bei einem Elektronenmikroskop mit im Strahlengang nacheinander symmetrisch zu einer Symmetrieebene derart angeordneten sechs Multipolen, daß die ersten drei vor und die zweiten drei nach der Symmetrieebene liegen, von denen alle zur Erzeugung von Quadrupolfeldern und von Oktupolfeldern dienen, wobei die Quadrupolfelder aller sechs Multipole von einem zum nächsten um 90° gedreht bezüglich ihrer Feldstärken (nicht ihrer Polarität) und punktsymmetrisch zum Schnittpunkt der optischen Achse mit der Symmetrieebene sind, wobei eine Austauschsymmetrie der axialen Fundamentalbahnen mit der Symmetrieebene als Spiegelebene für den Austausch entsteht und wobei sowohl die axialen als auch die außeraxialen Fundamentalbahnen am Ende des Korrektors wieder zusammengeführt werden, wobei durch das Zusammenwirken der als magnetische und elektrische Felder ausgebildeten Quadrupolfelder des dritten und vierten Multipols eine Farbfehlerkorrektur sowie mittels Einstellung von Oktupolfeldern, die in den Hauptschnitten dieselbe Kraftwirkung auf die Elektronen ausüben wie die Quadrupolfelder, eine Korrektur von Öffnungsfehlern und außeraxialen Fehlern, die durch das Korrektiv selbst erzeugt werden, möglich ist.

Der Zweck eines derartigen Korrektors besteht darin, daß die Farb- und Öffnungsfehler der optischen Bauteile des Mikroskops kompensierbar sind. Durch die Kompensation mittels solcher Korrektoren werden aber nicht nur Fehler von Strahlquelle und Linsen des Elektronenmikroskops kompensiert, sondern auch Fehler, die der Korrektor selbst verursacht.

Die Grundlage für die Funktion aller Korrektoren in der Teilchenoptik bildet die Erkenntnis von O. Scherzer (O. Scherzer: "Sphärische und chromatische Korrektur von Elektronen-Linsen" OPTIK, DE, JENA, 1947, Seiten 114-132, XP002090897, ISSN: 0863-0259), daß auch bei Teilchenstrahlen die Korrektur von Farb- und Öffnungs-fehlern möglich ist, wenn man mittels Quadrupolen nicht-rotationssymmetrische Felder erzeugt, um einen unrunden Strahl zu formen, an diesem die Fehlerkorrektur vornimmt und durch entgegengesetzt wirkende Felder den Strahl wieder rund macht. Die unrunden Strahlbereiche können astigmatische Zwischenbilder oder ein elliptischer Strahlbereich sein. Diese dienen dann der Fehlerkorrektur, wobei dazu mittels Multipolen Mehrpolfelder, wie Hexapolfelder, Oktupolfelder oder Zwölfpolfelder erzeugt werden. Diese Felder dienen dann ausschließlich der Vornahme von Korrekturen, sie haben keinen Einfluß auf die Fundamentalbahnverläufe. Lediglich die Farbfehlerkorrektur erfolgt mit Quadrupolfeldern, wobei sowohl in der x- als auch in der y-Richtung jeweils ein elektrischer und ein magnetischer Quadrupol zusammenwirken. O. Scherzer stellt die Bedingungen auf, unter denen solche Fehlerkorrekturen erreichbar sind (a.a.O.). Diese als Scherzer-Theorem bezeichneten Bedingungen sind Grundlage jeder Farb- und Öffnungsfehlerkorrektur in der Teilchenoptik.

Aus der DE 10 2007 049 816 B3 ist ein aus fünf Multipolelementen bestehender Korrektor bekannt, der jedoch in nicht unbedeutendem Maß Fehler höherer Ordnung selbst verursacht, was die Fehlerkompensation erschwert.

Aus der EP 2 068 344 A2 ist ein Korrektor bekannt, der von den Fehlerkorrekturmöglichkeiten dem erfindungsgemäßen Korrektor entspricht. Dieser besteht jedoch aus zwei Korrekturstücken gleichen Aufbaus, wodurch wesentlich mehr Multipole erforderlich sind. Dies ist technisch aufwendiger und führt zu einer größeren Bauhöhe.

Die DE 42 04 512 A1 hat einen Korrektor der eingangs genannten Art vorgeschlagen, der zwar weniger Fehler höherer Ordnung verursacht, jedoch eine azimutale Koma nicht beseitigt, was für die Verwendung eines Korrektors in einem Transmissionselektronenmikroskop erforderlich ist. Außerdem ist dieser Korrektor bezüglich Feldschwankungen der Quadrupolfelder äußerst empfindlich. Diese auch als "Rauschen" bezeichneten Feldschwankungen rühren von Schwankungen der Strom- bzw. Spannungsversorgung her. Die Empfindlichkeit gegenüber diesen Schwankungen erwiesen sich in der Testphase eines nach dieser Schrift gebauten Korrektors als so groß, daß es nicht mit vernünftigem technischen Aufwand möglich war, diese Empfindlichkeit durch hochstabile Versorgung mit elektrischer Energie in den Griff zu bekommen. Deshalb wurde die Realisierung dieses Korrektors einschließlich der genannten Patentanmeldung aufgegeben.

Der Erfindung liegt daher die Aufgabe zugrunde, einen Korrektor der eingangs genannten Art derart weiterzuentwickeln, daß er für Transmissionselektronenmikroskope geeignet und gegenüber Schwankungen der elektrischen Energieversorgung unempfindlich ist.

Die Aufgabe wird erfindungsgemäß dadurch gelöst, daß der Korrektor im Strahlengang derart anordenbar ist, daß der Elektronenstrahl derart konvergent zur optischen Achse eingestrahlt wird, daß die axialen Fundamentalbahnen ausschließlich in den Bereichen des dritten und vierten Multipols Maxima aufweisen, daß zwischen den beiden mittleren Multipolen ein Doppelmultipol angeordnet ist, der nebeneinanderliegend ein erstes Multipolelement vor und ein zweites Multipolelement nach der Symmetrieebene aufweist, wobei diese Multipolelemente ein erstes und ein zweites Oktupolfeld erzeugen, die in den Hauptschnitten dieselbe Richtung der Kraftwirkung auf die Elektronen ausüben wie die Quadrupolfelder, wobei das erste Multipolelement zusätzlich ein drittes Oktupolfeld und das zweite Multipolelement zusätzlich ein viertes Oktupolfeld erzeugen, die zueinander unterschiedlich gepolt und im Verhältnis zum ersten und zweiten Oktupolfeld in den Hauptschnitten eine gegenüber der optischen Achse um 90° gedrehte Richtung der Kraftwirkung auf die Elektronen ausüben, daß der dritte und vierte Multipol zum Schnittpunkt der optischen Achse und der Symmetrieebene spiegelsymmetrische Oktupolfelder erzeugen, deren Richtung der Kraftwirkung auf die Elektronen in den Hauptschnitten dem ersten und zweiten Oktupolfeld des Doppelmultipols entsprechen, jedoch zu diesen um 45° gedreht sind, daß die sechs Multipole Oktupolfelder erzeugen, die entsprechend der dritten und vierten Oktupolfelder des Doppelmultipols gegenüber der optischen Achse eine um 90° gedrehte Richtung der Kraftwirkung auf die Elektronen in den Hauptschnitten ausüben und bezüglich Feldstärke und Vorzeichen punktsymmetrisch zum Schnittpunkt von optischer Achse und Symmetrieebene sind, und daß die Einstellung der Polungen und Feldstärken der bezüglich der Richtung der Kraftwirkung auf die Elektronen in genannter Weise um 90° gedrehten Oktupolfelder der Korrektur der azimutalen Koma, bei der die Erzeugung anderer Fehler im wesentlichen vermieden wird, dienen.

Bei der Erfindung dienen die Oktupolfelder, welche dieselbe Orientierung haben wie die Quadrupolfelder, in derselben Weise wie bei der DE 42 04 512 A1 der Korrektur von Öffnungsfehlern. Dieselbe Orientierung von Oktupolfeldern gegenüber den Quadrupolfeldern bedeutet, daß sie dieselbe Richtung der Kraftwirkung auf die Elektronen in den Hauptschnitten ausüben wie die Quadrupolfelder.

Dagegen dienen die Oktupolfelder, die eine um 90° gedrehte Richtung der Kraftwirkung auf die Elektronen in den Hauptschnitten wie die Quadrupolfelder ausüben, der Korrektur der azimutalen Koma, wobei die Erzeugung anderer Fehler im wesentlichen vermieden wird. Dies bedeutet, daß gewisse Fehlererzeugungen durch die Korrektur der Koma, die sich nie völlig vermeiden lassen, die Bildqualität wesentlich weniger beeinträchtigen wie die beseitigte Koma. Dies ermöglicht es dann mit den Weiterbildungen der Erfindung solche Fehler wiederum zu beseitigen und danach auch eine durch diese Maßnahmen wiederauftretende Koma mittels der gedrehten Oktupolfelder in oben genannter Art zu beseitigen. Diese Schritte, mehrmals in einem iterativen Verfahren durchgeführt, führen dann zu einer derartigen Fehlerverringerung, daß man bezüglich der Bildqualität schließlich von Fehlerfreiheit sprechen kann. Die Erzielung der um 90° veränderten Kraftrichtung bedeutet bezüglich dieser Oktupolfelder, daß sie gegenüber den Quadrupolfeldern (und gegenüber den Oktupolfeldern gleicher Orientierung wie diese Quadrupolfelder) um 22,5° gedreht sind. Die Veränderung der Richtung der Kraftwirkung auf die Elektronen um 90° ergibt sich dann aus 4 x 22,5°, also 90°.

Um die Korrektur der azimutalen Koma zu erreichen, werden zielorientiert - also an Verringerung und schließlich dem Verschwinden der azimutalen Koma orientiert - die Polungen und Feldstärken dieser Otupolfelder variiert. Die Bedingungen für dieses Ziel können durch Versuchsreihen, aber auch durch Rechensimulationen ermittelt werden. Dabei sind die jeweiligen Polungen und Feldstärken von den jeweiligen Elektronenmikroskopen abhängig. Sie müssen für einzelne Bautypen ermittelt bzw. berechnet werden und auch für die einzelnen Geräte ist dann noch eine jeweilige Feinjustierung erforderlich.

Der erfindungsgemäße Korrektor ist außerdem gegenüber Schwankungen der elektrischen Energieversorgung wesentlich unempfindlicher, wodurch entweder der Aufwand für eine hochstabile Energieversorgung wesentlich verringert wird und/oder die Verschlechterung der Bildqualität durch solche Schwankungen vermieden wird.

Diese Empfindlichkeit gegen Schwankungen der Energieversorgung und damit der Feldstärken der jeweiligen Felder resultiert aus der Bahnhöhe der Fundamentalbahnen in den jeweiligen Quadrupolen, wobei die Empfindlichkeit quadratisch mit der Bahnhöhe zunimmt. Insbesondere spielen dabei die axialen Fundamentalbahnen eine Rolle. Beim erfindungsgemäßen Korrektor fallen die konvergent eintretenden Fundamentalbahnen x_{α} und y_{β} nach ihrem Eintritt in den ersten Quadrupol zum zweiten Quadrupol noch etwas ab. Im Gegensatz dazu hat beim Korrektor der DE 42 04 512 A1 die Fundamentalbahn y_{β} im zweiten Quadrupol ein Maximum, was sich dadurch, daß die Empfindlichkeit quadratisch zur Bahnhöhe zunimmt, besonders stark auswirkt. Entsprechendes gilt natürlich wegen der Punktsymmetrie (auch Antisymmetrie genannt) der Quadrupolfelder auch für den fünften und sechsten Quadrupol. Für den Korrekturerfolg bezüglich der Farb- und Öffnungsfehlerkorrektur sowie der Verringerung von Kombinationsfehlern sind jedoch derartige Maxima nur im dritten beziehungsweise vierten Quadrupol erforderlich. Auf diese Weise ist bei dem erfindungsgemäßen Korrektor, der nur diese Maxima aufweist, eine hochstabile Versorgung mit elektrischer Energie nur beim dritten und vierten Multipol notwendig. Es werden also nur dort Quadrupolfelder benötigt, die nahezu frei von Feldstärkeschwankungen sind. Alle anderen Multipole benötigen diese Präzision der Energieversorgung nicht. Dort wirken keine so starken Quadrupolfelder und es gibt keine so hohen Maxima von Fundamentalbahnen. Dadurch wird der Aufwand für die Versorgung mit elektrischer Energie wesentlich verringert, beziehungsweise wird dadurch eine Beeinträchtigung von Bildqualität und Auflösungsvermögen durch solche Schwankungen der elektrischen Versorgungsenergie vermieden.

Auf diese Weise wird durch die Erfindung sowohl eine Bildbeeinträchtigung durch Schwankungen der Energieversorgung, wie bei dem Korrektor der DE 42 04 512 A1, als auch die Entstehung von Fehlern höherer Ordnung, wie bei dem Korrektor der DE 10 2007 049 816 B3, vermieden und außerdem werden Kombinationsfehler 5. Ordnung und die azimutalen Koma beseitigt. Durch letzteres kann der Korrektor bei Transmissionselektronenmikroskopen eingesetzt werden.

Alle Felder des ersten, zweiten, fünften und sechsten Multipols, sowie die Oktupolfelder des dritten und vierten Multipolelements können dabei magnetische oder elektrische Felder oder eine Kombination von beidem sein. Dasselbe gilt für die Oktupolfelder des Doppelmultipols und für alle Zwölfpolfelder. Lediglich die Quadrupolfelder des dritten und vierten Multipols müssen zusammenwirkende elektrische und magnetische Felder sein.

Der erfindungsgemäße Korrektor geht zunächst von den vorbekannten Funktionen aus, daß nach der Lehre von O. Scherzer (a.a.O.) das Quadrupolfeld des ersten Multipols dem Strahl bezüglich der axialen und außeraxialen Fundamentalbahnen eine Abweichung von der Rotationssymmetrie aufprägt, so daß in zwei aufeinander senkrechten Hauptschnitten, dem x- und dem y-Schnitt, die Strahlen unterschiedlich divergierend verlaufen. Das nachfolgende, um 90° gedrehte Quadrupolfeld des zweiten Multipols bewirkt, daß die axialen Fundamentalbahnen noch stärker divergierend verlaufen und bewirkt gleichzeitig, daß die außeraxialen Fundamentalbahnen wieder aufeinander zu laufen. Im dritten Multipol, der im Verhältnis zu den beiden ersteren ein stärkeres Quadrupolfeld erzeugt, tritt ein Maximum von einer der axialen Fundamentalbahnen auf und im vierten Multipol ein Maximum der anderen axialen Fundamentalbahn. Diese Konstellation ermöglicht in Zusammenwirkung mit jeweils einem Oktupolfeld, das die gleiche Orientierung wie die Quadrupolfelder aufweist, eine wesentliche Verringerung der Kombinationsfehler 5. Ordnung.

Nach der Symmetrieebene zwischen dem dritten und vierten Multipol kommt es bezüglich der axialen Fundamentalbahnen x_{α} und y_{β} zu einer Austauschsymmetrie. Austauschsymmetrie in diesem Sinn heißt, daß ein Austausch der Strahlverläufe des x-Schnitts und des y-Schnitts stattfindet. Diese

Austauschsymmetrie ist eine Spiegelsymmetrie. Das heißt, nach der Symmtrieebene verläuft die Fundamentalbahn y_{β} spiegelsymmetrisch zur Fundamentalbahn x_{α} vor der Symmetrieebene und umgekehrt.

Bezüglich der außeraxialen Fundamentalbahnen x_{γ} und y_{δ} kommt es näherungsweise zu einer Austauschsymmetrie jedoch als Punktsymmetrie oder Antisymmetrie.

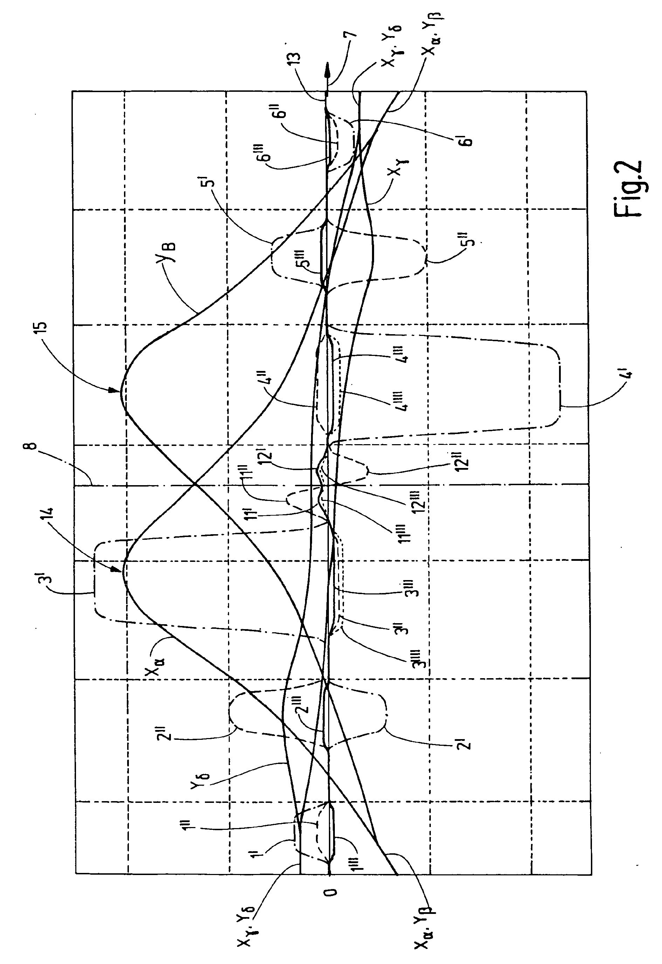

Damit tritt die oben beschriebene Konstellation auch im vierten Quadrupolfeld ein, nämlich, daß dort ein Maximum der anderen axialen Fundamentalbahn liegt. Dabei weist das Quadrupolfeld ein umgekehrtes Vorzeichen auf, ist also um 90° gedreht. Entsprechend liegt dann dort das Maximum der anderen axialen Fundamentalbahn, jedoch in einer um 90° gedrehten und damit bezüglich einer üblichen zeichnerischen Darstellung beider Schnitte x und y (siehe Fig. 2) in umgekehrter Ausrichtung zur optischen Achse. Dort wird dann die o. g. Korrektur in einem Bereich des Strahls bewirkt, der senkrecht zum vorgenannten Bereich liegt. Dies entspricht dem Prinzip von Scherzer, der Korrektur von Teilchenstrahlen durch die Deformierung des Strahls derart, daß dieser nacheinander im Bereich zweier senkrecht aufeinanderstehender Ebenen verläuft.

Durch die antisymmetrische bzw. punktsymmetrische Ausbildung der Quadrupolfelder, bei denen das erste und das sechste, das zweite und das fünfte und das dritte und das vierte jeweils betragsgleich, aber entgegengesetzt gerichtet sind, verläßt der Strahl, der als runder Strahl in den Korrektor eintritt, diesen wieder als runder Strahl.

Mittels der vorgenannten Deformationen des Strahls erfolgt auch die Farbfehlerkorrektur, wobei diese bezüglich eines Schnittes, beispielsweise des x-Schnittes, mit dem dritten Multipol und des anderen Schnittes, beispielsweise des y-Schnittes, mit dem vierten Multipol erfolgt. Die Funktion der Farbfehlerkorrektur entspricht dem bekannten Wienfilter und beruht darauf, daß die Quadrupolfelder aus sich überlagernden elektrischen und magnetischen Quadrupolfeldern bestehen. Die Feldstärken sind dabei so ausgelegt, daß Elektronen einer bestimmten Geschwindigkeit - also einer bestimmten Energie und in Relation zur Lichtoptik einer bestimmten Farbe - die Felder auf ihrem vorbestimmten Weg passieren. Die Elektronen abweichender Energien verlassen den vorbestimmten Weg. Dadurch kann man den Farbfehler der Rundlinsen des Mikroskops, insbesondere der Objektivlinse, kompensieren. Nur für diese Farbfehlerkorrektur ist daher die Kombination aus elektrischen und magnetischen Quadrupolfeldern erforderlich. Eine nähere Beschreibung dieser Farbfehlerkorrektur findet sich in H. Rose "Geometrical Charged-Particle Optics" unter "9.1.1 First-Order Wien Filter", Seiten 274 bis 277.

Bezüglich der Öffnungsfehler erfolgt die Korrektur ebenfalls im dritten und vierten Multipol sowie im Doppelmultipol jeweils mittels deren Oktupolfelder, die sich in gleicher Orientierung, also mit gleicher Kraftwirkung auf die Elektronen in den Hauptschnitten, befinden wie die Quadrupolfelder. Die Öffnungsfehler kommen von den rotationssymmetrischen Linsen des Elektronenmikroskops, da diese in größerer Entfernung von der optischen Achse verlaufende Strahlen stärker beeinflussen. Dies führt dazu, daß die Strahlen im Bereich von Zwischenbildern keinen gemeinsamen Schnittpunkt mit der optischen Achse bilden. Durch die unrunde Strahlverformung lassen sich die Strahlen mittels der Oktupolfelder derart beeinflussen, daß sich die Strahlen bei Zwischenbildern wieder alle in der Bildebene schneiden. Wird die Korrektur für die Strahlen eines jeden Schnittes nacheinander durchgeführt und diese Strahlen dann wieder zu einem runden Strahl zusammengeführt, ist die Öffnungsfehlerkorrektur erfolgt. Dabei ist es jedoch nicht nur möglich, Öffnungsfehler vorgeordneter Rundlinsen zu korrigieren, es können auch Fehler nachgeordneter Rundlinsen vorkompensiert werden. Dann wird dem Strahlengang ein derartiger Öffnungsfehler aufgeprägt, daß er sich mit den Öffnungsfehlern der nachgeordneten Rundlinsen, beispielsweise des Objektivs, wieder aufhebt.

Mit der Vornahme dieser vorbekannten Korrekturen tritt jedoch das Problem auf, daß der Korrektor seinerseits wiederum Fehler verursacht. Dabei handelt es sich vor allem um unrunde Fehler, insbesondere um einen vierzähligen Astigmatismus dritter Ordnung und einen Sternfehler fünfter Ordnung. Die unrunden Fehler bilden axiale Bildfehlerfiguren wie Astigmatismus, Sternfehler, Rosettenfehler und Koma, die in verschiedenen Ordnungen auftreten. Was weiterhin als runder Fehler verbleibt, ist ein Öffnungsfehler fünfter Ordnung, der, wie oben beschrieben, im Bereich der beiden Maxima der axialen Fundamentalbahnen im dritten und vierten Multipol weitgehend beseitigt werden kann.

Durch die oben schon beschriebene Einstellung des konvergent zur optischen Achse verlaufenden Strahlengangs können die Maxima der axialen Fundamentalbahnen in den Bereichen des dritten und vierten Multipols erzeugt werden, um Kombinationsfehler 5. Ordnung zu verringern. Da dies jedoch nur eine grobe Einstellung des Strahlengangs ist, kann zusätzlich eine Feinjustierung vorgenommen werden, mit der sich weitere Fehler beseitigen lassen.

Mittels einer derartigen Feinjustierung kann man erreichen, daß keine unrunden, komaartigen Fehler 3. Ordnung mehr erzeugt werden. Statt dessen kann man eine solche Feinjustierung auch dahingehend vornehmen, daß Rosettenfehler 5. Ordnung beseitigt sind. Eine weitere Alternative besteht darin, daß mittels dieser Feinjustierung runde Abbildungsfehler 5. Ordnung für die gewünschte Abbildung optimiert sind.

Das "Optimiert" ist auf der Grundlage zu verstehen, daß es nicht immer wünschenswert ist, die runden Abbildungsfehler 5. Ordnung völlig zu beseitigen, da ein runder Abbildungsfehler 5. Ordnung dazu dienen kann, einen besseren Phasenkontrast zu erzeugen. In einem solchen Fall ist unter "optimieren" zu verstehen, daß ein Abbildungsfehler 5. Ordnung nicht beseitigt, sondern in einer derartigen Größe eingestellt wird, daß der gewünschte Phasenkontrast erzielt wird.

Da durch die Feineinstellung nicht alle der vorgenannten Korrekturen bzw. die genannte Optimierung gleichzeitig erzielbar sind, hängt es von den konkreten Umständen einer gewünschten Abbildung ab, welcher Fehler mehr stört und daher beseitigt werden muß, oder ob der Erzeugung eines besseren Phasenkontrastes unter den jeweiligen konkreten Umständen der Vorzug zu geben ist.

Ein weiterer Vorschlag besteht darin, daß auch der erste, zweite, fünfte und sechste Multipol Oktupolfelder mit einer derartigen Orientierung zur optischen Achse erzeugen, daß diese dem ersten und zweiten Oktupolfeld des Doppelmultipols entsprechen und damit auch die gleiche Orientierung bzw. die gleiche Richtung der Kraftwirkung auf die Elektronen in den Hauptschnitten haben, wie dies bei den Quadrupolfeldern der Fall ist. Mit der Einstellung dieser Oktupolfelder können dann unrunde, komaartige Fehler 3. Ordnung beseitigt werden.

Um darüber hinaus auch alle Fehler bis zur 5. Ordnung bis auf kleine Restfehler zu kompensieren, wird vorgeschlagen, daß sowohl der Doppelmultipol als auch das dritte sowie das vierte Multipolelement Zwölfpolfelder erzeugen, um durch die entsprechende Einstellung derselben diese Korrekturen vorzunehmen.

Die nachfolgenden Weiterbildungen der Erfindung sehen vor, auch die noch vorhandenen Restfehler so weit wie möglich zu beseitigen. Diese kleinen Restfehler werden durch die sich außerhalb des Korrektors befindlichen Rundlinsen verursacht. Dabei handelt es sich insbesondere um einen zwar verminderten, aber doch noch störenden Öffnungsfehler 5. Ordnung. Als weitere Restfehler treten aber auch noch ein Rosettenfehler 5. Ordnung und eine radiale Koma 3. Ordnung auf.

Dazu wird vorgeschlagen, dem Korrektor objektivseitig zwei als Rundlinsen ausgebildete Transferlinsen zuzuordnen. Deren Felder können derart eingestellt werden, daß runde Fehler höherer Ordnung oder eine radiale Koma 3. Ordnung verschwindet. Auch hier wird alternativ die Korrektureinstellung gewählt, die für die jeweilige konkrete Abbildung den größten Gewinn an Bildqualität bringt.

Solche Transferlinsen mit ihren jeweiligen konkreten Einstellungen führen jedoch wiederum zu Fehlern. Insbesondere wird die Korrektur des Öffnungsfehlers dritter Ordnung sowie die Farbfehlerkorrektur teilweise wieder rückgängig gemacht. Deshalb ist ein Nachjustieren des dritten und vierten Multipols und des Doppelmultipols zweckmäßig. Dabei sind sowohl die der Farbfehlerkorrektur dienenden elektrischen und magnetischen Quadrupolfelder als auch die Oktupolfelder gleicher Orientierung des dritten und vierten Multipols sowie die Oktupolfelder gleicher Orientierung des Doppelmultipols nachzujustieren. Mittels der Oktupolfelder werden wiederauftretende Öffnungsfehler dritter Ordnung wieder beseitigt.

Eine wiederauftretende Koma wird durch eine Nachjustierung der Oktupolfelder bewirkt, die bezüglich der Richtung der Kraftwirkung auf die Elektronen in den Hauptschnitten gegenüber den Quadrupolfeldern um 90° gedreht sind.

Da die Einfügung der Transferlinsen sowie jede Verstellung, wie die vorgenannte Nachjustierung, den Strahlengang wieder verändert, ist es zweckmäßig, wiederauftretende Fehler höherer Ordnung durch eine Nachjustierung der Zwölfpolfelder der dritten und vierten Multipole und des Zwölfpolfeldes des Doppelmultipols zu beseitigen.

Da durch die Nachjustierung des dritten und vierten Multipols sowie des Doppelmultipoles wieder runde Fehler höherer Ordnung entstehen, sind die Transferlinsen wieder nachzujustieren. Danach folgt eine Nachjustierung der Quadrupolfelder des dritten und vierten Multipols zur Farbfehlerkorrektur, eine Nachjustierung der Oktupolfelder des dritten und vierten Multipols sowie des Doppelmultipols gleicher Orientierung wie die Quadrupolfelder zur Korrektur von Öffnungsfehlern dritter Ordnung, eine Nachjustierung der Oktupolfelder, die bezüglich der Richtung der Kraftwirkung auf die Elektronen gegenüber den Quadrupolfeldern um 90° gedreht sind, um eine Korrektur einer wieder aufgetretenen azimutalen Koma durchzuführen und schließlich eine Nachjustierung der Zwölfpolfelder zur Beseitigung wiederaufgetretener Fehler 5. Ordnung.

Da jede Verstellung der vorgenannten Elemente in angegebener Weise wieder Fehler zum Entstehen bringt, muß in iterativer Weise eine Wiederholung der vorgenannten Einzelschritte erfolgen, bis alle Fehler auf ein für die gewünschte Bildgebung tolerierbares Maß reduziert sind.

Ein Korrektor der erfindungsgemäßen Art läßt sich zwar prinzipiell in jedes Elektronenmikroskop einfügen. Besonders geeignet ist er jedoch für Transmissionselektronenmikroskope, da dieser Korrektor dafür sorgt, daß relativ große Bildbereiche fehlerfrei bzw. fehlerarm erzeugt werden können. Der erfindungsgemäße Korrektor weist dabei die baulichen Voraussetzungen, wie den räumlichen Aufbau, die Wicklungen und Materialeigenschaften sowie die erforderlichen Einstellbereiche für Strom und/oder Spannung zur Erzeugung und Regulierung der Feldstärken der jeweiligen magnetischen und/oder elektrischen Felder auf, um die beschriebenen Einstellungen und Justierungen beziehungsweise Nachjustierungen vornehmen zu können.

Die Charakterisierung von Feldern des Korrektors dahingehend, daß Einstellungen und Justierungen beziehungsweise Nachjustierungen möglich sind, bedeutet daher folgendes: Die baulichen Ausgestaltungen von Elektroden und/oder Elektromagneten und deren Beaufschlagungsmöglichkeit mit Strom beziehungsweise Spannung muß derart sein, daß nach dem Einbau des Korrektors in ein Elektronenmikroskop die angegebenen Korrekturmaßnahmen möglich sind. Durchgeführt werden diese Einstellungen, Justierungen und Nachjustierungen nach dem Einbau und der Inbetriebnahme des jeweiligen Elektronenmikroskops, da die konkreten Einstellungen sowohl von der Bauart des Elektronenmikroskops als auch von den individuellen Linsenfehlern abhängt, welche auch bei Elektronenmikroskopen der gleichen Baureihen individuell auftreten, beispielsweise durch Maßungenauigkeiten und Materialinhomogenitäten. Auch muß beim Betrieb eines Elektronenmikroskops von Zeit zu Zeit eine Nachjustierung erfolgen, da schon geringste Verschmutzungen die optischen Eigenschaften verändern und eine solche erforderlich machen können. Realisiert ist die Erfindung in einem Korrektor, der diese Korrekturmöglichkeiten des Elektronenstrahls ermöglicht. Die Konkretisierung der baulichen Ausgestaltung des Korrektors sowie die konkret zur Verfügung gestellten Strom und/oder Spannungsbereiche, die für die Einstellungen und Korrekturen erforderlich sind, richten sich nach der Bauart des jeweiligen Elektronenmikroskops, insbesondere nach den jeweiligen Strahlspannungen der möglichen Arbeitsbereiche und der konkreten Ausgestaltung der Linsensysteme.

Da die angegebenen Eigenschaften des erfindungsgemäßen Korrektors ihre Wirkung nach dem Einbau in ein Elektronenmikroskop entfalten, betrifft die Erfindung auch ein mit dem Korrektor ausgestattetes Transmissionselektronenmikroskop, bei dem die Vorzüge des Korrektors durch die Fehlerreduzierung in relativ großen Bildbereichen besonders zur Geltung kommen.

Die Erfindung wird nachfolgend anhand von schematischen Darstellungen und Ausführungsbeispielen der Zeichnung erläutert. Es zeigen
- **Fig. 1**: eine schematische Darstellung des erfindungsgemäßen Korrektors,
- **Fig. 2**: entsprechend zu Fig. 1 den Strahlenverlauf in den Ebenen x und y sowie die Anordnung der Felder,
- **Fig. 3**: eine schematische Teilansicht eines Transmissionselektronenmikroskops mit einem Korrektor,
- **Fig. 4**: eine schematische Darstellung eines Zwölfpolelements, das ein Oktupolfeld erzeugt,
- **Fig. 5**: eine schematische Darstellung eines Zwölfpolelements mit einer Darstellung der Erzeugung verschiedener Felder und
- **Fig. 6a, 6b, 6c**: Potentialverteilungen verschiedener Felder.

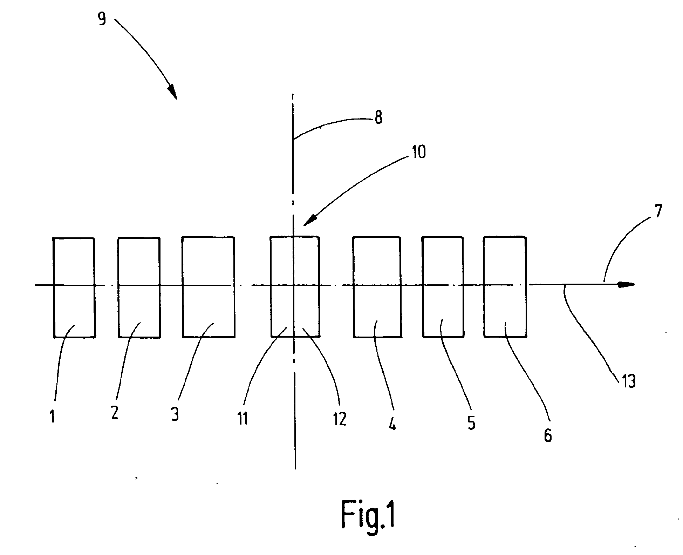

Fig. 1 zeigt eine schematische Darstellung des erfindungsgemäßen Korrektors 9. In Richtung des Strahlengangs 7 sind entlang der optischen Achse 13 ein erster 1, ein zweiter 2 und ein dritter Multipol 3 angeordnet. Nach einer Symmetrieebene 8 folgen dann drei weitere Multipole 4, 5, 6, wobei diese zu den Multipolen 1, 2 und 3 bezüglich der Anordnung symmetrisch sind und auch eine baugleiche symmetrische Zuordnung in Bezug auf die Symmetrieebene 8 aufweisen müssen. Dabei entspricht der Multipol 1 dem Multipol 6, der Multipol 2 dem Multipol 5 und der Multipol 3 dem Multipol 4.

In der Symmetrieebene 8 ist ein Doppelmultipol 10 angeordnet, der nebeneinanderliegend ein erstes Multipolelement 11 vor und ein zweites Multipolelement 12 nach der Symmetrieebene 8 aufweist.

Fig. 2 zeigt den Strahlverlauf des Korrektors 9, der sowohl die für den Grundgedanken der Erfindung erforderlichen Felder, als auch die Felder für die Weiterbildungen der Erfindung aufweist.

Dargestellt sind zwei senkrecht aufeinanderstehende Ebenen, also der x-Schnitt und der y-Schnitt mit den Strahlengängen der axialen Fundamentalbahnen x_{α} und y_{β} sowie der außeraxialen Fundamentalbahnen x_{γ} und y_{δ}. Dabei verlaufen die Fundamentalbahnen x_{α} und x_{γ} in der x-Ebene und die Fundamentalbahnen y_{β} und y_{δ} in der y-Ebene, welche senkrecht entlang der optischen Achse 13 auf der x-Ebene steht. Des weiteren zeigt Fig. 2 die Felder, welche durch die Multipole 1, 2, 3, 4, 5 und 6 sowie den Doppelmultipol 10 erzeugt werden. Der Strahlengang geht in Richtung des Pfeils 7 und die optische Achse 13 verläuft durch die "0" der senkrechten Skala.

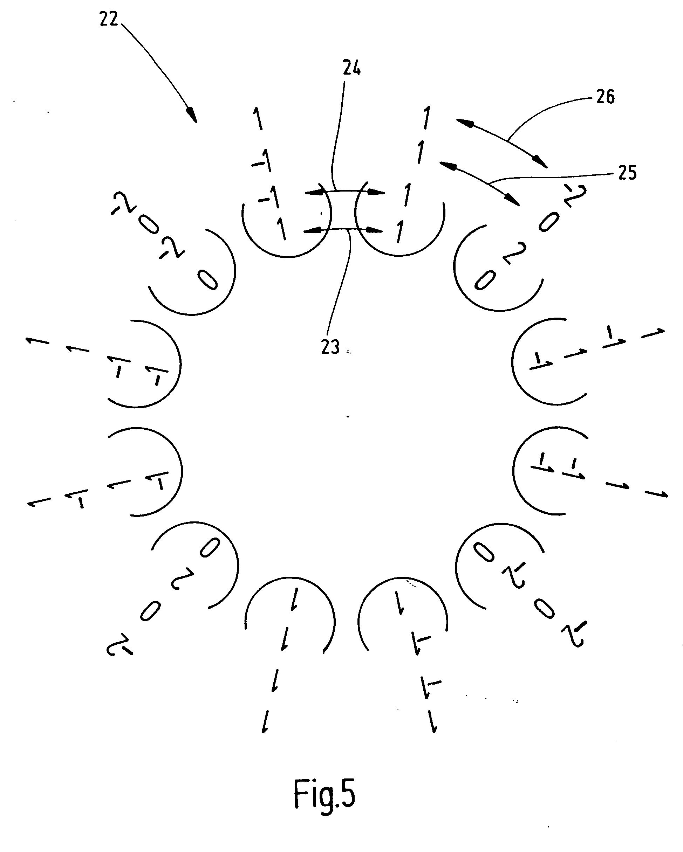

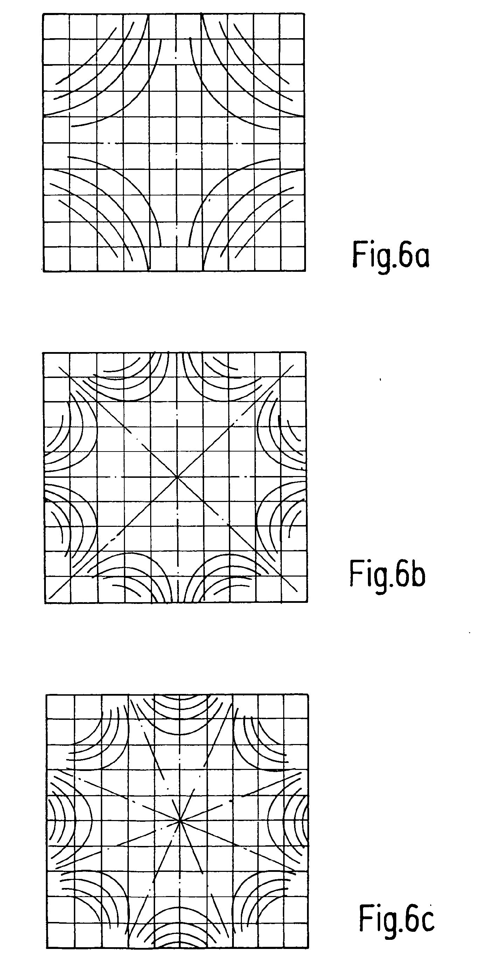

Dabei sind der erste 1, der zweite 2, der fünfte 5 und der sechste Multipol 6 zur Erzeugung von Quadrupolfeldern 1', 2', 5' und 6' ausgebildet, wobei es sich um elektrische oder magnetische Quadrupolfelder 1', 2', 5', 6' oder eine Kombination von beiden handeln kann. Die Multipole 1, 2, 5 und 6 müssen dazu mindestens vier Elektromagnete und/oder vier Elektroden in axialsymmetrischer Anordnung zur optischen Achse 13 aufweisen. Da sie nach den Weiterbildungen auch noch andere Felder erzeugen sollen, werden sie zweckmäßigerweise in üblicher Art als Zwölfpolelemente 22 (siehe Fig. 5 und 6) ausgebildet.

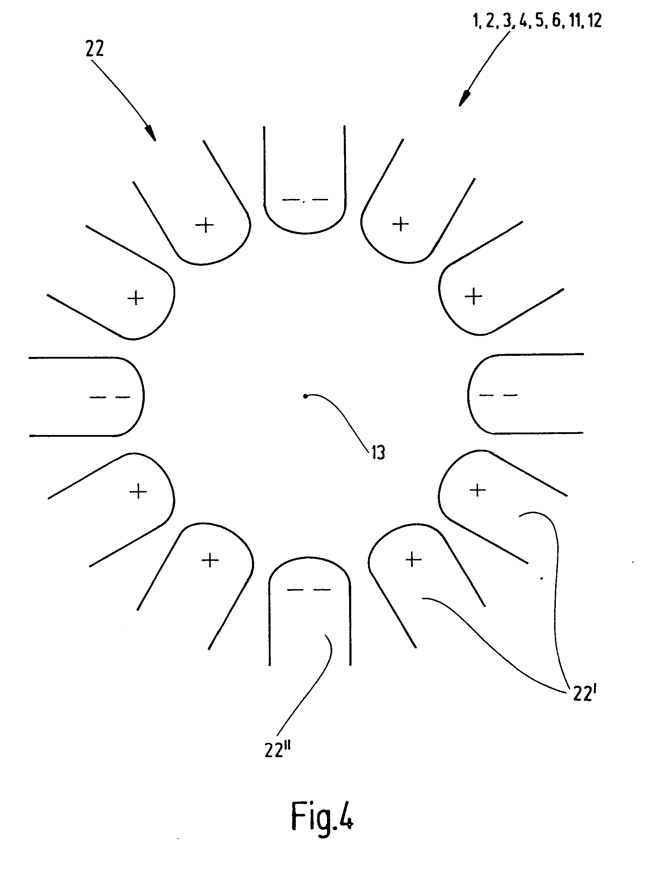

Der dritte 3 und vierte Multipol 4 sind in der Regel ebenfalls als Zwölfpolelemente 22 (siehe Fig. 4 und 5) ausgebildet, wobei sie elektrische und magnetische Quadrupolfelder 3', 4' erzeugen können, indem beispielsweise die Weicheisenkerne der Elektromagneten gleichzeitig als Elektroden dienen. Der dritte 3 und vierte Multipol 4 werden dabei derart mit Strom für die Elektromagneten bzw. mit einem Potential für die Elektroden beaufschlagt, daß diese einander überlagernde magnetische sowie elektrische Quadrupolfelder 3', 4' erzeugen, die derart zusammenwirken, daß die eingangs beschriebene Farbfehlerkorrektur erfolgen kann.

Alle sechs Multipole 1, 2, 3, 4, 5, 6 erzeugen Oktupolfelder 1", 2", 3", 4", 5", 6", die gegenüber den vorgenannten Quadrupolfeldern 1', 2', 3', 4', 5', 6' in den Hauptschnitten x, y eine um 90° gedrehte Richtung der Kraftwirkung auf die Elektronen aufweisen (siehe dazu Fig. 6a und 6c).

Weiterhin erzeugen alle sechs Multipole 1, 2, 3, 4, 5, 6 weitere Oktupolfelder 1"', 2"', 3"', 4"', 5"', 6"', die gegenüber den Quadrupolfeldern 1', 2', 3', 4', 5', 6' in den Hauptschnitten x, y die gleiche Richtung einer Kraftwirkung auf die Elektronen aufweisen (siehe Fig. 6a und 6b).

Der zwischen den Multipolen 3 und 4 befindliche Doppelmultipol 10 erzeugt mit den nebeneinanderliegenden Multipolelementen 11 und 12, zwischen denen die Symmetrieebene 8 liegt, ein erstes und ein zweites Oktupoplfeld 11' und 12', welche dieselbe Richtung der Kraftwirkung auf die Elektronen ausüben wie die Quadrupolfelder 1', 2', 3', 4', 5', 6'. Weiterhin erzeugt das erste Multipolelement 11 ein drittes Oktupolfeld 11" und das zweite Multipolelement 12 ein viertes Oktupolfeld 12", die eine um 90° gegenüber der optischen Achse 13 gedrehte Kraftrichtung auf die Elektronen ausüben wie die Quadrupolfelder 1', 2', 3', 4' und 5'. Dabei sind das dritte und vierte Oktupolfeld 11" und 12" zueinander um 45° gedreht und damit in der Zeichnung punktsymmetrisch zum Schnittpunkt der optischen Achse 13 mit der Symmetrieebene 8.

Schließlich erzeugen der dritte und der vierte Multipol 3 und 4 sowie die beiden Multipolelemente 11 und 12 des Doppelmultipols 10 noch die Zwölfpolfelder 3"", 4"", 11"" und 12"", wobei die letztgenannten 11"" und 12"" spiegelsymmetrisch zur Symmetrieebene 8 liegen.

Wesentlich für den durch die Quadrupolfelder 1', 2', 3', 4', 5' und 6' erzeugten Strahlengang der axialen x_{α}, y_{β} und außeraxialen Fundamentalbahnen x_{γ}, y_{δ} ist zunächst eine derartige konvergente Einstrahlung zur optischen Achse 13, daß die axialen Fundamentalbahnen x_{α} und y_{β} ausschließlich in den Bereichen des dritten und vierten Multipols 3, 4 Maxima 14 und 15 aufweisen. Dabei bewirkt das erste Quadrupolfeld l' eine Deformierung des runden Strahls mit einem Auseinanderlaufen der axialen x_{α}, x_{β} und außeraxialen Fundamentalbahnen x_{γ}, y_{δ}. Das zweite Quadrupolfeld 2' bewirkt einen stärkeren Anstieg der axialen Fundamentalbahnen x_{α} und ein Abfallen der außeraxialen Fundamentalbahnen y_{δ}. Im dritten Quadrupolfeld 3' kommt es zu einem Maximum 14 der axialen Fundamentalbahn x_{α}, die danach wieder abfällt und einem stärkeren Anstieg der axialen Fundamentalbahn y_{β}, so daß diese im vierten Quadrupolfeld 4' ein Maximum 15 aufweist.

Nach der Symmetrieebene 8 verlaufen die axialen Fundamentalbahnen x_{α} und y_{β} in spiegelsymmetrischer Weise in der Art einer Austauschsymmetrie zwischen den Fundamentalbahnen x_{α} und y_{β}, wobei sie sich in der Symmetrieebene 8 kreuzen. Die außeraxialen Fundamentalbahnen x_{γ}, y_{δ} bilden annähernd einen Austausch in punktsymmetrischer Weise, um den Kreuzungspunkt von optischer Achse 13 und Symmetrieebene 8. Am Ende des Korrektors laufen die axialen Fundamentalbahnen x_{α} und y_{β} sowie die außeraxialen Fundamentalbahnen x_{γ} und y_{δ} wieder zusammen und bilden wieder einen runden Strahl.

Zunächst wird durch den Korrektor 9 die oben schon erwähnte und bekannte Farbfehlerkorrektur erzielt, indem die Quadrupolfelder 3' und 4' als zusammenwirkende magnetische und elektrische Quadrupolfelder 3', 4' ausgebildet sind.

Weiterhin findet eine Korrektur von Öffnungsfehlern und außeraxialen Fehlern, die durch den Korrektor 9 selbst verursacht werden, dadurch statt, daß Oktupolfelder 3"', 4"' des dritten und vierten Multipols 3, 4, die die gleiche Orientierung wie die Quadrupolfelder 1', 2', 3', 4', 5', 6' aufweisen und gemeinsam mit einem zentralen Oktupolfeld diese Korrektur vornehmen. Der Unterschied zum eingangs erwähnten Korrektor der DE 42 04 512 A1 besteht diesbezüglich lediglich darin, daß sich das zentrale Oktupolfeld beim erfindungsgemäßen Korrektor 9 aus den ersten beiden aneinandergrenzenden Oktupolfeldern 11' und 12' des Doppelmultipols 10 zusammensetzt.

Die erfindungsgemäße Funktion der Korrektur der azimentalen Koma, bei der im wesentlichen eine Erzeugung anderer Fehler vermieden wird, wird durch Oktupolfelder 1 ", 2", 3", 4", 5", 6", 11", 12" erzielt, die gegenüber den Quadrupolfeldern 1', 2', 3', 4', 5', 6' in den Hauptschnitten x, y in der Richtung ihrer Kraftwirkung auf die Elektronen eine Drehung dieser Kraftwirkung um 90° aufweisen. Dabei handelt es sich um die Oktupolfelder 1 ", 2", 3", 4", 5", und 6" der Multipole 1, 2, 3, 4, 5 und 6 sowie um das dritte und vierte Oktupolfeld 11" und 12" der Multipolelemente 11 und 12 des Doppelmultipols 10.

Bezüglich der Weiterbildungen der Erfindung, die mittels Feinjustierungen der konvergenten Einstrahlung des Elektronenstrahls x_{α}, y_{β}, x_{γ} und y_{δ} zur optischen Achse 13 weitere Korrekturen ermöglichen, wird auf die obigen Ausführungen verwiesen.

Eine Weiterbildung der Erfindung sieht vor, daß auch der erste, zweite, fünfte und sechste Multipol 1, 2, 5, 6 Oktupolfelder 1"', 2"', 5"', 6'" mit einer derartigen Orientierung zur optischen Achse 13 erzeugen, daß diese bezüglich der Kraftwirkung auf die Elektronen in den Hauptschnitten x, y den Quadrupolfeldern 1', 2', 3', 4', 5', 6' und damit auch dem ersten und zweiten Oktupolfeld 11', 12' des Doppelmultipols 10 entsprechen. (Die oben genannten Oktupolfelder 1", 2", 3", 4", 5", 6" sind gegenüber diesen somit um 22,5° gedreht - siehe Fig. 6b und 6c -, was der veränderten Richtung der Kraftwirkung auf die Elektronen in den Hauptschnitten x, y mit einer Drehung um 90° zur optischen Achse 13 entspricht.) Alle diese Oktupolfelder 1'" 2"', 3"', 4"', 5"', 6"' sowie das erste und zweite Oktupolfeld 11' und 12' des Doppelmultipols 10 dienen dazu, zusätzlich unrunde komaartige Fehler 3. Ordnung zu beseitigen.

Eine weitere zweckmäßige Weiterbildung bringt Zwölfpolfelder 3"', 4"', 11"', 12'" des dritten und vierten Multipols 3, 4 und des Doppelmultipols 10 zum Einsatz, um alle axialen Fehler bis zur 5. Ordnung zu korrigieren.

Bei allen diesen Korrekturen muß angemerkt werden, daß jede Korrektur eines Fehlers wieder andere Fehler, allerdings in abgeschwächter Form, verursacht. Deshalb müssen hier wieder Nachkorrekturen erfolgen. Aus diesem Grund müssen alle Korrekturschritte nacheinander mehrmals erfolgen, um sich mit dem oben bereits erwähnten iterativen Verfahren einem Fehlerminimum von akzeptierbarer Größe anzunähern, wie dies bereits oben beschrieben wurde.

Die senkrecht zu einander verlaufenden Schnitte x und y mit den Fundamentalbahnen x_{α} und x_{γ} im x-Schnitt und der Fundamentalbahnen y_{β} und y_{δ} im y-Schnitt dienen natürlich nur der Darstellung der Strahlverformung, welche man sich räumlich vorstellen muß. Bei den unrunden Feldern, verhält es sich wie bei den Zylinderlinsen in der Lichtoptik, in der es ebenfalls möglich ist, durch die Anordnung entgegenwirkender Zylinderlinsen die herbeigeführte Verzeichnung eines Strahlengangs wieder zu eliminieren. Die Verzeichnung dient hier dazu, Farbfehler und Öffnungsfehler sowie weitere Fehler eines Elektronenstrahls nach dem Scherzer-Theorem zu korrigieren.

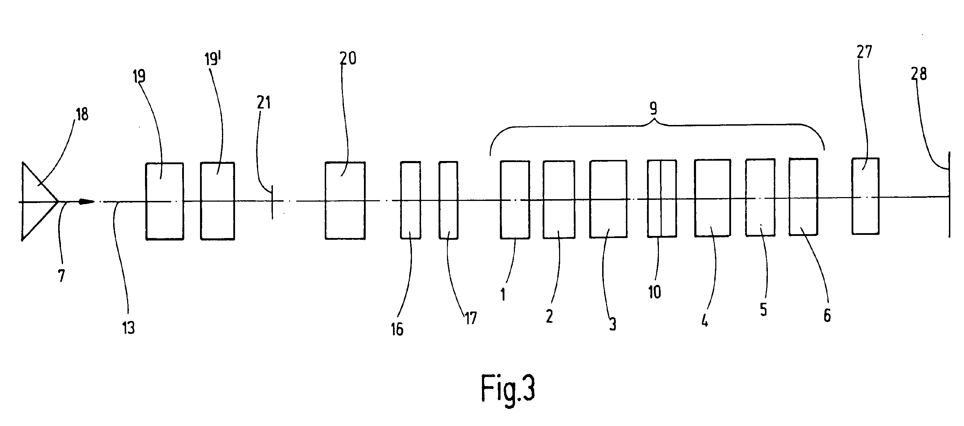

Fig. 3 zeigt eine schematische Teilansicht eines Transmissionselektronenmikroskops. Im Strahlengang 7 folgen nach der Strahlenquelle 18 entlang der optische Achse 13 zuerst die Kondensorlinsen 19, 19', dann das Objekt 21 und nachfolgend das Objektiv 20. Daran schließen sich die Transferlinsen 16 und 17 und der Korrektor 9 an. In der bereits beschriebenen Weise kann mit der Einstellung der Transferlinsen 16 und 17 und der iterativen Einstellung von Korrektor 9 und Transferlinsen 16, 17 die Korrekturqualität weiter verbessert werden. Nach dem Korrektor 9 folgt schließlich das Projektiv 27 und danach die Bildebene 28.

Fig. 4 zeigt eine schematische Darstellung eines als Zwölfpolelement 22 ausgebildeten Multipolelements, wobei es sich um eines der Multipole 1, 2, 3, 4, 5, 6 oder eines der Multipolelemente 11, 12 des Doppelmultipols 10 handeln kann. Zwölf Pole 22', 22" sind achssymmetrisch um die optische Achse 13 angeordnet.

Soll mit dem Zwölfpolelement 22 ein Zwölfpolfeld 3"', 4"', 11"', 12"' erzeugt werden, so sind die Pole 22', 22" der Reihe nach immer abwechselnd als Nord- und Südpole zur Erzeugung von magnetischen Feldern oder als negativ und positiv geladene Elektroden zur Erzeugung von elektrischen Feldern ausgebildet.

Soll eine Kombination eines elektrischen und eines magnetischen Feldes erzeugt werden, so dienen die Weicheisenkerne der Elektromagneten gleichzeitig als Elektroden, die mit einer Spannung beaufschlagt sind.

Soll ein Quadrupolfeld 1', 2', 3', 4', 5' oder 6' erzeugt werden, so sind immer drei Pole 22', 22", also Magnete oder Elektroden, mit gleicher Polarität oder Ladung zusammengefaßt und die Dreiergruppen wechseln als Nord- und Südpole oder als negativ beziehungsweise positiv geladene Elektroden ab. Auch dabei können elektrische und magnetische Felder überlagert sein. Eine solche Überlagerung kann, wie oben zur Farbfehlerkorrektur mittels der magnetischen und elektrischen Felder 3' und 4' ausgeführt, einem Zusammenwirken in der Art eines Wienfilters dienen. Ein solches Zusammenwirken kann aber auch als Feldverstärkung ausgebildet werden.

Sollen dagegen, wie dargestellt, Oktupolfelder erzeugt werden, so müssen sich die Pole 22', 22", wie durch die "+" und "-" Zeichen gekennzeichnet, abwechseln. Es folgen also zwei positiv geladene Pole 22' und ein negativ geladener Pol 22" in abwechselnder Reihe, wobei die negative Ladung (wie durch die zwei "-" Zeichen symbolisiert) entsprechend verstärkt sein muß, um ein möglichst unverzerrtes Oktupolfeld zu erzielen. Bei der Erzeugung eines magnetischen Oktupols verhält sich dies dann entsprechend. Die genannte abwechselnde Reihe kann auch mit umgekehrten Ladungen ausgeführt werden.

Überlagerte Felder, wie Quadrupolfeld, Oktupolfeld und Zwölfpolfeld, erzeugt durch ein einziges Zwölfpolelement 22, erhält man dadurch, daß in den jeweiligen Polen 22', 22" - also in den Elektromagneten oder Elektroden - die Ströme bzw. Spannungen aufsummiert werden. Auf diese Weise lassen sich alle oben erwähnten Feldüberlagerungen herstellen.

**Fig. 5** zeigt eine Veranschaulichung der Erzeugung verschiedener Felder durch ein Zwölfpolelement 22 in schematischer Darstellung.

Dabei sind verschiedene Polbelegungen mit Ziffern, die in konzentrischen Kreisen angeordnet sind, eingetragen, wobei die positiven Ladungen elektrischer Pole oder die Südpole magnetischer Pole ohne Vorzeichen sind, die negativen Ladungen elektrischer Pole oder die Nordpole magnetischer Pole mit einem "-" bezeichnet sind und keine Polbelegungen mit einer "0".

Der innerste konzentrische Kreis zeigt die Potentialverteilung 23 bei einem elektrischen Quadrupol und der darauffolgende konzentrische Kreis die Potentialverteilung 24 bei einem magnetischen Quadrupol.

Beide Polbelegungen 23 und 24 können auch als zusammenwirkender elektrischmagnetischer Quadrupol ausgebildet sein.

Die Potentialverteilung 25 des nächsten konzentrischen Kreises gibt entweder einen magnetischen Oktupol an oder einen dazu um 22,5° gedrehten elektrischen Oktupol. Dies kommt daher, weil bei Elektromagneten die Kräfte senkrecht zum Feld wirken, bei Elektroden aber parallel zum Feld. Aus diesem Grund ist bei Oktupolen eine gegenseitige Drehung um 22,5° vorhanden, wenn gleiche Polbelegungen vorgenommen werden.

In entsprechender Weise gibt die Potentialverteilung 26 des nächsten konzentrischen Kreises entweder die Polbelegung eines elektrischen Oktupols an oder eines zu letzterem um 22,5° gedrehten magnetischen Oktupols.

Werden die Polbelegungen verschiedener Potentialverteilungen 23, 24, 25 oder 26 aufsummiert, werden einander überlagerte Felder erzeugt.

Die **Fig. 6a, 6b und 6c** zeigen schließlich die Potentialverteilungen verschiedener Felder am Beispiel von magnetischen Potentiallinien. Dabei zeigt die **Fig. 6a** die Potentiallinien eines Quadrupolfeldes und die **Fig. 6b** die Potentiallinien eines Oktupolfeldes gleicher Orientierung. Gleiche Orientierung heißt, daß das Quadrupolfeld nach Fig. 6a in den Hauptschnitten die gleiche Richtung der Kraftwirkung auf die Elektronen ausübt wie das Oktupolfeld der Fig. 6b.

Dagegen ist das Oktupolfeld der **Fig. 6c** gegenüber dem Oktupolfeld der Fig. 6b um 22,5° gedreht. Dies bedeutet, daß die Richtung der Kraftwirkung der Elektronen in den Hauptschnitten x, y des Oktupolfeldes der Fig. 6c gegenüber dem Oktupolfeld der Fig. 6b um 90° gedreht ist.

### Korrektor

### Bezugszeichenliste

- 1, 2, 3, 4, 5, 6: Multipole
- 1', 2', 3', 4', 5', 6': Quadrupolfelder der Multipole 1, 2, 3, 4, 5 und 6 [strichpunktierte Linien]
- 1", 2", 3", 4", 5", 6": Oktupolfelder der Multipole 1, 2, 3, 4, 5 und 6 (mit in den Hauptschnitten x, y gegenüber den Quadrupolfeldern eine um 90° gedrehte Richtung der Kraftwirkung auf die Elektronen) [gestrichelte Linien]
- 1"', 2"', 3"', 4"', 5"', 6"': Oktupolfelder der Multipole 1, 2, 3, 4, 5, 6 (mit in den Hauptschnitten x, y derselben Richtung der Kraftwirkung auf die Elektronen wie die Quadrupolfelder) [durchgezogene Linien]
- 3"", 4"": Zwölfpolfelder der Multipole 3, 4 [punktierte Linien]
- 7: Strahlengang
- 8: Symmetrieebene
- 9: Korrektor
- 10: Doppelmultipol
- 11, 12: Multipolelemente des Doppelmultipols 10
- 11': erstes Oktupolfeld des Doppelmultipols (Richtung der Kraftwirkung auf die Elektronen in den Hauptschnitten wie Quadrupolfelder) [durchgezogene Linie]
- 12': zweites Oktupolfeld des Doppelmultipols (Richtung der Kraftwirkung auf die Elektronen in den Hauptschnitten wie Quadrupolfelder) [durchgezogene Linie]
- 11": drittes Oktupolfeld des Doppelmultipols (gegenüber den Quadrupolen um 90° gedrehte Richtung der Kraftwirkung auf die Elektronen in den Hauptschnitten) [gestrichelte Linie]
- 12": viertes Oktupolfeld des Doppelmultipols (gegenüber den Quadrupolen um 90° gedrehte Richtung der Kraftwirkung auf die Elektronen in den Hauptschnitten) [gestrichelte Linie]
- 1l'", 12"': Zwölfpolfelder des Doppelmultipols [punktierte Linien]
- 13: optische Achse
- 14: Maximum der axialen Fundamentalbahn x_{α}
- 15: Maximum der axialen Fundamentalbahn y_{β}
- 16, 17: Transferlinsen
- 18: Strahlquelle
- 19, 19': Kondensorlinsen
- 20: Objektiv
- 21: Objekt
- 22: Zwölfpolelement
- 22': Pole, als Elektromagnet und/oder Elektrode ausgebildet - Südpol der positiv geladenen Elektrode
- 22": Pole, als Elektromagnet und/oder Elektrode ausgebildet - Nordpol der negativ geladenen Elektrode
- 23: Potentialverteilung bei einem elektrischen Quadrupol
- 24: Potentialverteilung bei einem magnetischen Quadrupol
- 25: Potentialverteilung bei einem magnetischen Oktupol oder einen dazu um 22,5° gedrehten elektrischen Oktupol
- 26: Potentialverteilung bei einem elektrischen Oktupol oder einem dazu um 22,5° gedrehten magnetischen Oktupol
- 27: Projektiv
- 28: Bildebene
- x, y: Schnitte
- x_{α}, y_{β}: axiale Fundamentalbahnen
- x_{γ}, y_{δ}: außeraxiale Fundamentalbahnen

## Patentansprüche

1. Korrektor (9) für die Farb- und Öffnungsfehlerkorrektur bei einem Elektronenmikroskop mit im Strahlengang (7) nacheinander symmetrisch zu einer Symmetrieebene (8) derart angeordneten sechs Multipolen (1, 2, 3, 4, 5, 6), daß die ersten drei (1, 2, 3) vor und die zweiten drei (4, 5, 6) nach der Symmetrieebene (8) liegen, von denen alle zur Erzeugung von Quadrupolfeldern (1', 2', 3', 4', 5', 6') und von Oktupolfeldern dienen, wobei die Quadrupolfelder (1', 2', 3', 4', 5', 6') aller sechs Multipole (1, 2, 3, 4, 5, 6) von einem zum nächsten um 90° gedreht bezüglich ihrer Feldstärken und punktsymmetrisch zum Schnittpunkt der optischen Achse (13) mit der Symmetrieebene (8) sind, wobei eine Austauschsymmetrie der axialen Fundamentalbahnen (x_{α}, y_{β}) mit der Symmetrieebene (8) als Spiegelebene für den Austausch entsteht und wobei sowohl die axialen (x_{α}, y_{β}) als auch die außeraxialen Fundamentalbahnen (x_{γ}, y_{δ}) am Ende des Korrektors (9) wieder zusammengeführt werden, wobei durch das Zusammenwirken der als magnetische und elektrische Felder (3', 4') ausgebildeten Quadrupolfelder (3', 4') des dritten (3) und vierten (4) Multipols eine Farbfehlerkorrektur sowie mittels Einstellung von Oktupolfeldern (3"', 4"') des dritten (3) und vierten Multipols (4), die in den Hauptschnitten (x, y) dieselbe Richtung der Kraftwirkung auf die Elektronen ausüben wie die Quadrupolfelder (1', 2', 3', 4', 5', 6'), eine Korrektur von Öffnungsfehlern und außeraxialen Fehlern, die durch den Korrektor (9) selbst erzeugt werden, möglich ist,
**dadurch gekennzeichnet,**
**daß** der Korrektor (9) im Strahlengang (7) derart anordenbar ist, daß der Elektronenstrahl derart konvergent zur optischen Achse (13) eingestrahlt wird, daß die axialen Fundamentalbahnen (x_{α}, y_{β}) ausschließlich in den Bereichen des dritten und vierten Multipols (3, 4) Maxima (14, 15) aufweisen, daß zwischen den beiden mittleren
Multipolen (3, 4) ein Doppelmultipol (10) angeordnet ist, der nebeneinanderliegend ein erstes Multipolelement (11) vor und ein zweites Multipolelement (12) nach der Symmetrieebene (8) aufweist, wobei diese Multipolelemente (11, 12) ein erstes und ein zweites Oktupolfeld (11', 12') erzeugen, die in den Hauptschnitten (x, y) dieselbe Richtung der Kraftwirkung auf die Elektronen ausüben wie die Quadrupolfelder (1', 2', 3', 4', 5', 6'), wobei das erste Multipolelement (11) zusätzlich ein drittes Oktupolfeld (11") und das zweite Multipolelement (12) zusätzlich ein viertes Oktupolfeld (12") erzeugen, die zueinander unterschiedlich gepolt und im Verhältnis zum ersten und zweiten Oktupolfeld (11', 12') in den Hauptschnitten (x, y) eine gegenüber der optischen Achse (13) um 90° gedrehte Richtung der Kraftwirkung auf die Elektronen ausüben,
**daß** der dritte und vierte Multipol (3, 4) zum Schnittpunkt der optischen Achse (13) und der Symmetrieebene (8) spiegelsymmetrische Oktupolfelder (3"', 4"') erzeugen, deren Richtung der Kraftwirkung auf die Elektronen in den Hauptschnitten (x, y) dem ersten und zweiten Oktupolfeld (11', 12') des Doppelmultipols (10) entsprechen, jedoch zu diesen um 45° gedreht sind, daß die sechs Multipole (1, 2, 3, 4, 5, 6) Oktupolfelder (1", 2", 3", 4", 5", 6") erzeugen, die entsprechend der dritten und vierten Oktupolfelder (11", 12") des Doppelmultipols (10) gegenüber der optischen Achse (13) eine um 90° gedrehte Richtung der Kraftwirkung auf die Elektronen in den Hauptschnitten (x, y) ausüben und bezüglich Feldstärke und Vorzeichen punktsymmetrisch zum Schnittpunkt von optischer Achse (13) und Symmetrieebene (8) sind, und
**daß** die Einstellung der Polungen und Feldstärken der bezüglich der Richtung der Kraftwirkung auf die Elektronen in vorgenannter Weise um 90° gedrehten Oktupolfelder (1", 2", 3", 4", 5", 6", 11 ", 12") der Korrektur der azimutalen Koma, bei der die Erzeugung anderer Fehler im wesentlichen vermieden wird, dienen.

2. Korrektor nach Anspruch 1, der bezüglich der konvergenten Einstrahlung des Elektronenstrahls zur optischen Achse (13) derart feinjustierbar ist, daß keine unrunden, komaartigen Fehler 3. Ordnung mehr erzeugt werden.

3. Korrektor nach Anspruch 1, der bezüglich der konvergenten Einstrahlung des Elektronenstrahls zur optischen Achse (13) derart feinjustierbar ist, daß Rosettenfehler 5. Ordnung beseitigt sind.

4. Korrektor nach Anspruch 1, der bezüglich der konvergenten Einstrahlung des Elektronenstrahls zur optischen Achsed (13) derart feinjustierbar ist, daß runde Öffnunsisfehler 5. Ordnung beseitigtbar sind.

5. Korrektor nach Anspruch 3 oder 4,
**dadurch gekennzeichnet,**
**daß** auch der erste, zweite, fünfte und sechste Multipol (1, 2, 5, 6) Oktupolfelder (1"', 2"', 5"', 6"') mit einer derartigen Orientierung zur optischen Achse (13) erzeugen, daß diese bezüglich der Kraftwirkung auf die Elektronen in den Hauptschnitten (x, y) dem ersten und zweiten Oktupolfeld (11', 12') des Doppelmultipols (10) entsprechen und daß mit diesen Oktupolfeldern (1''', 2''', 5''', 6"') unrunde komaartige Fehler 3. Ordnung beseitigt werden.

6. Korrektor nach einem der Ansprüche 1 bis 5,
**dadurch gekennzeichnet,**
**daß** zur Korrektur aller axialen Fehler bis zur 5. Ordnung der Doppelmultipol (10) und der dritte und vierte Multipol (3, 4) Zwölfpolfelder (11"', 12"', 3"", 4"") erzeugen.

7. Anordnung mit einem Korrektor nach Anspruch 6,
**dadurch gekennzeichnet,**
**daß** die Anordnung zwei als Rundlinsen ausgebildete Transferlinsen (16, 17) enthält, die im Strahlengang vor dem Korrektor stehen.

8. Anordnung nach Anspruch 7,
**dadurch gekennzeichnet,**
**daß** die Felder der Transferlinsen (16, 17) so einstellbar sind, daß die runden Fehler höherer Ordnung verschwinden.

9. Anordnung nach Anspruch 7,
**dadurch gekennzeichnet,**
**daß** die Felder der Transferlinsen (16, 17) so einstellbar sind, daß die radiale Koma 3. Ordnung verschwindet.

10. Anordnung nach Anspruch 7, 8 oder 9,
**dadurch gekennzeichnet,**
**daß** eine Nachjustierung der Quadrupol- (3', 4') und der Oktupolfelder (3"', 4"', 11', 12') des dritten (3) und vierten Multipols (4) und des Doppelmultipols (10) mit gleicher Richtung der Kraftwirkung auf die Elektronen in den Hauptschnitten (x, y) wie die Quadrupolfelder (1', 2', 3', 4', 5', 6') möglich ist, derart, daß der durch die vorgenannte Einstellung der Transferlinsen (16, 17) erneut verursachte Farbfehler erster und Öffnungsfehler dritter Ordnung wieder beseitigt sind.

11. Anordnung nach Anspruch 10,
**dadurch gekennzeichnet,**
**daß** eine Nachjustierung der bezüglich der Richtung der Kraftwirkung auf die Elektronen in den Hauptschnitten (x, y) gegenüber den Quadrupolfeldern (1', 2', 3', 4', 5', 6') um 90° gedrehten Oktupolfelder (1", 2", 3", 4", 5", 6", 11", 12") zur Beseitigung einer wiederauftretenden Koma vorgenommen werden kann.

12. Anordnung nach Anspruch 11,
**dadurch gekennzeichnet,**
**daß** eine Nachjustierung der Zwölfpolfelder (3"", 4"", 11'", 12'") des dritten (3) und vierten Multipols (4) und des Doppelmultipols (10) möglich ist, um die durch die Nachjustierung Transferlinsen (16, 17) und die vorgenannten Nachjustierungen wieder aufgetretenen Fehler höherer Ordnungen wieder zu beseitigen.

13. Transmissionselektronenmikroskop mit einer Anordnung nach Anspruch 12,
**dadurch gekennzeichnet,**
**daß** zur Beseitigung der wieder aufgetretenen Farbfehler erster und Öffnungsfehler dritter sowie Fehler höherer Ordnung durch eine Nachjustierung von Transferlinsen (16, 17), eine Nachjustierung von Quadrupolfeldern (3', 4') und Oktupolfeldern (3"', 4"', 11', 12') sowie eine Nachjustierung der bezüglich der Richtung der Kraftwirkung auf die Elektronen in oben genannter Weise um 90° gedrehten Oktupolfelder (1", 2", 3", 4", 5", 6", 11 ", 12") zur Korrektur der azimutalen Koma, eine Nachjustierung der Einstrahlung des Elektronenstrahls und danach eine Nachjustierung der Zwölfpolfelder (3"", 4"", 11"', 12"') zur Beseitigung der Fehler 5. Ordnung sowie eine iterative Einstellung in den vorgenannten Schritten zur Verminderung der durch die jeweils vorangegangenen Nachjustierungen wiederum verursachten Fehler möglich ist.

14. Transmissionselektronenmikroskop,
**gekennzeichnet durch**
seine Ausstattung mit einem Korrektor (9) zur Korrektur des Elektronenstrahls nach einem der Ansprüche 1 bis 6 oder **durch** seine Ausstattung mit einer Anordnung nach einem der Ansprüche 7 bis 10.

## Claims

1. A corrector (9) for chromatic and spherical aberration correction in an electron microscope with six multipoles (1, 2, 3, 4, 5, 6) arranged consecutively in the beam path (7) symmetrically to a plane of symmetry (8), in such a manner that the first three (1, 2, 3) are before and the second three (4, 5, 6) after the plane of symmetry (8), all of which are used to produce quadrupole fields (1', 2', 3', 4', 5', 6') and octupole fields, wherein the quadrupole fields (1', 2', 3', 4', 5', 6') of all six multipoles (1, 2, 3, 4, 5, 6) are rotated through 90° from one to the next in relation to their field strengths and are point-symmetrical to the point of intersection of the optical axis (13) with the plane of symmetry (8), wherein a replacement symmetry of the axial fundamental paths (x_{α}, y_{β}) with the plane of symmetry (8) as the mirror plane for the replacement is created and wherein both the axial (x_{α}, y_{β}) and also the extra-axial fundamental paths (x_{γ}, y_{δ}) at the end of the corrector (9) are guided together again, wherein through the interaction of the quadrupole fields (3', 4') configured as magnetic and electrical fields (3', 4') of the third (3) and fourth (4) multipole, a chromatic aberration correction is possible and also by setting octupole fields (3''', 4"') of the third (3) and fourth multipole (4), which exert the same force effect direction on the electrons in the main sections (x, y) as the quadrupole fields (1', 2', 3', 4', 5', 6'), a correction of spherical aberrations and extra-radial aberrations which are produced by the corrector (9) itself is possible,
**characterized in that**
the corrector (9) can be arranged in the beam path (7) in such a manner that the electron beam is radiated convergently to the optical axis (13) in such a manner that the axial fundamental paths (x_{α}, y_{β}) only have maximum points (1.4, 15) in the regions of the third and fourth multipoles (3, 4),
that a double multipole (10) is arranged between the two centre multipoles (3, 4), which double multipole has a first multipole element (11) before and a second multipole element (12) after the plane of symmetry (8), wherein these multipole elements (11, 12) produce a first and a second octupole field (11', 12') which in the main sections (x, y) exert the same force effect direction on the electrons as the quadrupole fields (1', 2', 3', 4', 5', 6'), wherein the first multipole element (11) additionally produces a third octupole field (11'') and the second multipole element (12) additionally produces a fourth octupole field (12") which have different poles to one another and in respect of the first and second octupole field (11', 12') in the main sections (x, y) exert a force effect direction on the electrons that is rotated about 90 ° compared with the optical axis (13),
that the third and four multipole (3, 4) produce mirror-symmetrical octupole fields (3''', 4''') at the intersection point of the optical axis (13) and the plane of symmetry (8), the force effect direction of said octupole fields to the electrons in the main sections (x, y) corresponding to the first and second octupole field (11', 12') of the double multipole (10), but being rotated about 45 ° in respect of these, that the six multipoles (1, 2, 3, 4, 5, 6) produce octupole fields (1'', 2'', 3'', 4'', 5'', 6'') which exert a force effect direction on the electrons in the main sections (x, y) rotated about 90° in respect of the optical axis (13) corresponding to the third and fourth octupole fields (11'', 12'') of the double multipole (10) and in respect of field strength and algebraic sign are point-symmetrical to the point of intersection of the optical axis (13) and the plane of symmetry (8), and
that the setting of the poles and field strengths of the octupole fields (1'', 2'', 3'', 4'', 5'', 6'', 11'', 12'') rotated about 90 ° in respect of the force effect direction to the electrons in the aforementioned manner serves to correct the azimuth coma, with which the production of other aberrations is substantially avoided.

2. The corrector according to claim 1,
which can be finely adjusted in respect of the convergent radiation of the electron beam to the optical axis (13), in such a manner that no more irregular, coma-like, third-order aberrations can be produced.

3. The corrector according to claim 1,
which can be finely adjusted in respect of the convergent radiation of the electron beam to the optical axis (13), in such a manner that fifth-order rosette aberrations are removed.

4. The corrector according to claim 1,
which can be finely adjusted in respect of the convergent radiation of the electron beam to the optical axis (13), in such a manner that round, fifth-order spherical aberrations can be removed.

5. The corrector according to claim 3 or 4,
**characterized in that**
the first, second, fifth and sixth multipole (1, 2, 5, 6) also produce octupole fields (1''', 2''', 5''', 6''') with an orientation of this kind to the optical axis (13), that these correspond to the first and second octupole field (11', 12') of the double multipole (10) in respect of the force effect on the electrons in the main sections (x, y) and that irregular, coma-like, third-order aberrations are removed with these octupole fields (1"', 2"', 5"', 6''').

6. The corrector according to one of claims 1 to 5,
**characterized in that**
in order to correct all axial aberrations up to fifth order, the double multipole (10) and the third and fourth multipole (3, 4) produce twelve-pole fields (11"", 12"", 3"", 4"").

7. An arrangement with a corrector according to claim 6,
**characterized in that**
the arrangement contains two transfer lenses (16, 17) configured as round lenses which stand in the beam path before the corrector.

8. The arrangement according to claim 7,
**characterized in that**
the fields of the transfer lenses (16, 17) can be adjusted in such a manner that the higher-order round aberrations disappear.

9. The arrangement according to claim 7,
**characterized in that**
the fields of the transfer lenses (16, 17) are adjustable in such a manner that the third-order radial coma disappears.

10. The arrangement according to claim 7, 8 or 9,
**characterized in that**
a readjustment of the quadrupole (3', 4') and octupole fields (3''', 4"', 11', 12') of the third (3) and fourth multipole (4) and the double multipole (10) in the same direction of the force effect on the electrons in the main sections (x, y) as the quadrupole fields (1', 2', 3', 4', 5', 6') is possible, in such a manner that through the aforementioned setting of the transfer lenses (16, 17) repeated chromatic aberrations of first order and spherical aberrations of third order can be removed again.

11. The arrangement according to claim 10,
**characterized in that**
a readjustment can be performed of the octupole fields (1", 2", 3'', 4'', 5", 6", 11", 12'') rotated about 90° compared with the quadrupole fields (1', 2', 3', 4', 5', 6') in respect of the force action direction on the electrons in the main sections (x, y) to remove a recurring coma.

12. The arrangement according to claim 11,
**characterized in that**
a readjustment of the twelve pole fields (3'''', 4"", 11''', 12''') of the third (3) and fourth (4) multipole and the double multipole (10) is possible, in order once again to remove the higher-order aberrations recurring through the readjustment of transfer lenses (16, 17) and the aforementioned readjustments.

13. A transmission electron microscope with an arrangement according to claim 12,
**characterized in that**
in order to remove the recurring chromatic aberrations of first order the spherical aberrations of third order and also higher-order aberrations through a readjustment of transfer lenses (16, 17), a readjustment of quadrupole fields (3', 4') and octupole fields (33"', 4''', 11', 12') and also a readjustment of the octupole fields (1", 2", 3", 4", 5", 6", 11", 12'') rotated about 90° in respect of the force action direction on the electrons in the aforementioned manner to correct the azimuth coma, a readjustment of the radiation of the electron beam and thereafter a readjustment of the twelve-pole fields (3'''', 4'''', 11''', 12''') to remove the fifth-order aberrations and also an iterative adjustment in the aforementioned steps to reduce the aberrations likewise caused by each of the preceding readjustments is possible.

14. The transmission electron microscope,
**characterized by**
its fitting with a corrector (9) to correct the electron beam according to one of claims 1 to 6 or by its fitting with an arrangement according to one of claims 7 to 10.

## Revendications

1. Correcteur (9) pour la correction d'aberrations chromatiques et sphériques dans un microscope électronique avec six multipôles (1, 2, 3, 4, 5, 6) disposés successivement dans le trajet de faisceau (7) symétriquement à un plan de symétrie (8) d'une manière telle, que les trois premiers (1, 2, 3) se situent avant le plan de symétrie (8) et les trois suivants (4, 5, 6) après celui-ci, l'ensemble d'entre eux servant à la production de champs quadripolaires (1', 2', 3', 4', 5', 6') et de champs octopolaires, dans lequel les champs quadripolaires (1', 2', 3', 4', 5', 6') de l'ensemble des six multipôles (1, 2, 3, 4, 5, 6) sont tournés de l'un au suivant de 90° en ce qui concerne leurs intensités de champ et en symétrie ponctuelle au point d'intersection entre l'axe optique (13) et le plan de symétrie (8), dans lequel une symétrie d'échange des pistes axiales fondamentales (x_{α}, y_{β}) avec le plan de symétrie (8) est produite en tant que plan de miroir pour l'échange, et dans lequel les pistes axiales fondamentales (x_{α}, y_{β}), tout comme également les pistes désaxées fondamentales (x_{γ}, y_{δ}). sont de nouveau réunies à l'extrémité du correcteur (9), dans lequel, grâce à la coopération des champs quadrupolaires (3', 4'), réalisés en tant que champs magnétiques et électriques (3', 4'), des troisième (3) et quatrième (4) multipôles, une correction d'aberrations chromatiques est possible ainsi que, à l'aide du réglage de champs octopolaires (3''', 4''') des troisième (3) et quatrième (4) multipôles qui exercent dans les sections principales (x, y) la même direction d'effet de la force sur les électrons que les champs quadripolaires (1', 2', 3', 4', 5', 6'), une correction d'aberrations sphériques et d'aberrations de désaxement qui sont produites par le correcteur (9) lui-même, sont possibles,
**caractérisé en ce que**
le correcteur (9) peut être disposé dans le trajet de faisceau (7) d'une manière telle, que le faisceau d'électrons irradie de façon convergente à l'axe optique (13) de manière à ce que les pistes axiales fondamentales (x_{α}, y_{β}) présentent des maximums (14, 15) exclusivement dans les zones des troisième et quatrième multipôles (3, 4),
**en ce qu'**un double multipôle (10) est disposé entre les deux multipôles (3, 4) du milieu, lequel présente de façon juxtaposée un premier élément multipolaire (11) avant le plan de symétrie (8) et un deuxième élément multipolaire (12) après celui-ci, dans lequel ces éléments multipolaires (11, 12) produisent un premier et un deuxième champ octopolaire (11', 12'), lesquels exercent la même direction d'effet de la force sur les électrons dans les sections principales (x, y) que les champs quadripolaires (1', 2', 3', 4', 5', 6'), dans lequel le premier élément multipolaire (11) produit additionnellement un troisième champ octopolaire (11'') et le deuxième élément multipolaire (12) produisant additionnellement un quatrième champ octopolaire (12''), lesquels sont polarisés différemment l'un par rapport à l'autre et exercent, par rapport au premier et deuxième champ octopolaire (11', 12'), une direction d'effet de la force sur les électrons tournée de 90° par rapport à l'axe optique (13) dans les sections principales (x, y),
**en ce que** les troisième et quatrième multipôles (3, 4) produisent des champs octopolaires (3''', 4"') en symétrie spéculaire au point d'intersection entre l'axe optique (13) et le plan de symétrie (8), dont la direction de l'effet de la force sur les électrons dans les sections principales (x, y) correspond aux premier et deuxième champs octopolaires (11', 12') du double multipôle (10), en présentant cependant une rotation de 45° par rapport à ceux-ci, **en ce que** les six multipôles (1, 2, 3, 4, 5, 6) produisent des champs octopolaires (1", 2", 3", 4", 5", 6") lesquels, de manière correspondante aux troisième et quatrième champs octopolaires (11", 12'') du double multipôle (10), exercent par rapport à l'axe optique (13) une direction tournée de 90° de l'effet de la force sur les électrons dans les sections principales (x, y) et sont, en ce qui concerne l'intensité de champ et le signe, en symétrie ponctuelle par rapport au point d'intersection entre l'axe optique (13) et le plan de symétrie (8), et
**en ce que** le réglage des polarisations et intensités de champ des champs octopolaires (1", 2", 3", 4", 5", 6", 11", 12''), tournés de l'ordre de 90° de la manière susmentionnée par rapport à la direction de l'effet de la force sur les électrons, sert à la correction de la coma azimutale lors de laquelle la production d'autres aberrations est sensiblement évitée.

2. Correcteur selon la revendication 1,
lequel est ajustable avec précision concernant l'irradiation convergente du faisceau d'électrons par rapport à l'axe optique (13) de manière à ne plus produire d'aberrations asphériques de type coma de 3ème ordre.

3. Correcteur selon la revendication 1,
lequel, en ce qui concerne l'irradiation convergente du faisceau d'électrons par rapport à l'axe optique (13), est ajustable avec précision d'une manière telle, que des aberrations de rosette de 5ème ordre sont éliminées.

4. Correcteur selon la revendication 1,
lequel, en ce qui concerne l'irradiation convergente du faisceau d'électrons par rapport à l'axe optique (13), est ajustable avec précision d'une manière telle, que des aberrations sphériques rondes de 5ème ordre peuvent être éliminées.

5. Correcteur selon la revendication 3 ou 4,
**caractérisé en ce qu'**
également les premier, deuxième, cinquième et sixième multipôles (1, 2, 5, 6) produisent des champs octopolaires (11"', 2''', 5''', 6''') avec une orientation telle par rapport à l'axe optique (13), qu'en ce qui concerne l'effet de la force sur les électrons dans les sections principales (x, y), ceux-ci correspondent aux premier et deuxième champs octopolaires (11', 12') du double multipôle (10) et **en ce qu'**avec ces champs octopolaires (1''', 2''', 5''', 6"'), on élimine des aberrations asphériques de type coma de 3ème ordre.

6. Correcteur selon l'une des revendications 1 à 5,
**caractérisé en ce que**,
pour la correction de toutes les aberrations axiales jusqu'au 5ème ordre, le double multipôle (10) et les troisième et quatrième multipôles (3, 4) produisent des champs à douze pôles (11''', 12''', 3'''', 4'''').

7. Dispositif avec un correcteur selon la revendication 6,
**caractérisé en ce que**
le dispositif contient deux lentilles de transfert (16, 17) réalisées en tant que lentilles rondes, lesquelles sont devant le correcteur dans le trajet du faisceau.

8. Dispositif selon la revendication 7,
**caractérisé en ce que**
les champs des lentilles de transfert (16, 17) sont réglables d'une manière telle, que les aberrations sphériques d'ordre supérieur disparaissent.

9. Dispositif selon la revendication 7,
**caractérisé en ce que**
les champs des lentilles de transfert (16, 17) sont réglables d'une manière telle, que la coma radiale de 3ème ordre disparaît.

10. Dispositif selon la revendication 7, 8 ou 9,
**caractérisé en ce qu'**
un ajustement ultérieur des champs quadrupolaires (3', 4') et octopolaires (3''', 4''', 11', 12') des troisième (3) et quatrième (4) multipôles et du double multipôle (10) est possible avec une direction identique de l'effet de la force sur les électrons dans les sections principales (x, y) que pour les champs quadrupolaires (1', 2', 3', 4', 5', 6'), de manière à ce que l'aberration chromatique de premier ordre et l'aberration sphérique de troisième ordre nouvellement produites par le réglage susmentionné des lentilles de transfert (16, 17) soient de nouveau éliminées.

11. Dispositif selon la revendication 10,
**caractérisé en ce qu'**
il est possible de procéder à un ajustement ultérieur des champs octopolaires (1", 2", 3", 4", 5", 6", 11", 12") tournés de 90° par rapport aux champs quadrupolaires (1', 2', 3', 4', 5', 6') en ce qui concerne la direction de l'effet de la force sur les électrons dans les sections principales (x, y) pour l'élimination d'une coma qui réapparaît.

12. Dispositif selon la revendication 11,
**caractérisé en ce qu'**
un ajustement ultérieur des champs à douze pôles (3''', 4'''', 11'''', 12'''') des troisième (3) et quatrième (4) multipôles et du double multipôle (10) est possible afin de de nouveau éliminer les aberrations d'ordre supérieur de nouveau apparues du fait de l'ajustement ultérieur des lentilles de transfert (16, 17) et des ajustements susmentionnés.

13. Microscope électronique à transmission avec un dispositif selon la revendication 12,
**caractérisé en ce que**
pour éliminer des aberrations chromatiques de premier ordre et des aberrations sphériques de troisième ordre réapparues ainsi que des aberrations d'ordre supérieur du fait d'un ajustement ultérieur de lentilles de transfert (16, 17), un ajustement ultérieur de champs quadrupolaires (3', 4') et de champs octopolaires (3''', 4''', 11', 12') ainsi qu'un ajustement ultérieur des champs octopolaires (1'', 2'', 3", 4'', 5'', 6'', 11'', 12'') tournés de l'ordre de 90° de la manière mentionnée ci-dessus concernant la direction d'effet de la force sur les électrons pour la correction de la coma azimutale, un ajustement ultérieur de l'irradiation du faisceau d'électrons et ensuite un ajustement ultérieur des champs à douze pôles (3"", 4'''', 11''', 12''') pour l'élimination de l'aberration de 5ème ordre ainsi qu'un réglage itératif lors des étapes susmentionnées pour réduire les aberrations de nouveau produites par les ajustements ultérieurs respectivement susmentionnés, sont possibles.

14. Microscope électronique à transmission,
**caractérisé par**
son équipement d'un correcteur (9) pour la correction du faisceau d'électrons selon l'une des revendications 1 à 6 ou son équipement d'un dispositif selon l'une des revendications 7 à 10.
